# EUROPEAN PATENT APPLICATION

(11) **EP 3 012 544 A1**
(43) Date of publication of application: **27.04.2016**
(21) Application number: 15020085.5
(22) Date of filing: 01.04.2010
(51) Int. Cl.: F24F 11/00, H05K 7/20, F24F 11/02, F24F 13/22

(54) **A COOLING UNIT**

(30) Priority: 03.04.2009 GB 0905871
(62) Divisional of application: 10712760.7
(71) Applicant: EATON-WILLIAMS GROUP LIMITED, Edenbridge, Kent TN8 6EG (GB)
(72) Inventor: LUXFORD, Mark, Gillingham, Kent ME7 4BW (GB); MORGAN, David, Tunbridge Wells, Kent TN2 5HQ (GB)
(74) Representative: Crouch, David John

(57) **Abstract**

A method of cooling air in a space. The method comprises pumping coolant fluid through primary and secondary circuits (26 and 43) having respective portions thermally coupled within a primary heat exchanger (24) so that the coolant fluid in the primary circuit (26) conditions the coolant fluid in the secondary circuit (43). The coolant fluid is distributed in the secondary circuit (43) to at least one secondary heat exchanger (142) positioned with a space. An ambient dew point of the space is monitored with a sensor (260, 262). A parameter of coolant fluid in the primary circuit (26) is controlled based on the ambient dew point to reduce condensation in the space.

## Description

The present invention relates to a cooling distribution unit comprising a first passageway through which coolant fluid is pumped when the unit is in use, and a second passageway through which coolant fluid is pumped when the unit is in use, portions of the first and second passageways being thermally coupled to one another so as to constitute a heat exchanger, the coolant fluid which passes through the said second passageway when the unit is in use being distributed to a multiplicity of heat exchangers respectively associated with a multiplicity of blade racks in a data centre.

A problem associated with such apparatus is that it is not readily adapted to cope with a change in the ambient dew point of the data centre.

If the ambient dew point changes, condensation may occur in such a fashion as to put the operation of the blades at risk.

The present invention seeks to provide a remedy.

Accordingly, the present invention is directed to a cooling distribution unit having a construction as set out in the opening paragraph of the present specification, in which the unit is provided with a humidity sensor connected to a control processor of the unit and located in the data centre when the unit is in use to enable the control processor to determine the ambient dew point in the data centre, the control processor being connected to control operation of the unit in dependence upon that ambient due point, in which the unit further comprises a variable control valve in the said first passageway connected to the control processor to enable the latter to control operation of the unit in dependence upon the said ambient dew point by adjusting the variable control valve in the said first passageway to alter the rate of flow of coolant therein, so as to reduce the likelihood of condensation occurring within the data centre when the unit is in use.

This provides an advantage that the risk of condensation in the data centre is averted without upsetting the distribution of coolant to the blade racks.

In the present specification hereinafter the word "deceeds" shall be taken to mean the opposite of "exceeds", so that for example if a parameter is below a given threshold, or falls below a given threshold, it may be considered that that parameter "deceeds" that threshold. The usual grammatical and syntactical principles shall be taken to apply to that word.

At least one temperature sensor may be provided to give an indication of the temperature of the coolant in the said second passageway, which temperature sensor is connected to the control processor to enable the latter to adjust the variable control valve in the first passageway to ensure that the amount by which the temperature of the coolant in the said second passageway exceeds the ambient dew point does not deceed a predetermined threshold value.

The unit may further comprise at least one selectively adjustable variable control valve in the said second passageway to enable the amount of fluid which passes through that passageway to be selectively adjusted.

In one preferred embodiment of the present invention, the said second passageway is part of a coolant circuit comprising a common upstream header which extends to respective locations adjacent to such a multiplicity of blade racks when the unit is in use and which is provided with a multiplicity of outlets respectively connected to inlets of such a multiplicity of heat exchangers when the unit is in use, and a common downstream header provided with a multiplicity of inlets respectively connected to outlets of such a multiplicity of heat exchangers when the unit is in use.

Such a construction of cooling distribution unit provides reliability in the supply of coolant to the heat exchangers of respective racks, and is suitable especially for installation at the time a data centre is being constructed.

Advantageously, each outlet from the common upstream header is provided with a selectively adjustable variable control valve to enable adjustment of fluid flow to and from a given blade rack to suit that rack.

In another preferred embodiment of the present invention, the unit is provided with a frame which supports the said first and second passageways and also on outlet manifold from the said second passageway and an inlet manifold to the said second passageway. Whilst such a construction of cooling distribution unit can be used for an installation at the time a data centre is being constructed, it is especially useful for retro fitting to an existing data centre.

Preferably the connections to the inlets and the outlets are by way of quick release connectors, for example bayonet connectors. Preferably each connection between an inlet or an outlet and a respective heat exchanger associated with such a blade rack is by way of a flexible hose having respective quick release connectors at its two ends. This provides for ease of installation.

Advantageously, each outlet of the outlet manifold is provided with a respective selectively adjustable variable control valve to enable adjustment of fluid flow to and from a given blade rack to suit that rack.

The present invention extends to a method of cooling the air in a data centre using a cooling distribution unit in accordance with the present invention and as set out in one or more of the preceding paragraphs.

An example of a cooling distribution unit made in accordance with the present invention will now be described in greater detail with reference to the accompanying drawings, in which:
- Figure 1: is a perspective view of a cooling distribution unit embodying the present invention viewing it from the front and to one side;
- Figure 2: is a perspective view of the unit shown in Figure 1 viewing it from the rear and from the other side;
- Figure 2a: shows in exploded form a first modification of the unit shown in Figures 1 and 2;
- Figure 2b: shows in exploded form a second modification of the unit shown in Figures 1 and 2;
- Figure 3: shows a perspective view from one side and from above of a data centre incorporating a cooling distribution unit as shown in Figures 1 and 2; and
- Figure 4: shows both a fluid circuit and an electronic circuit of the cooling distribution unit shown in Figures 1, 2 and 3.

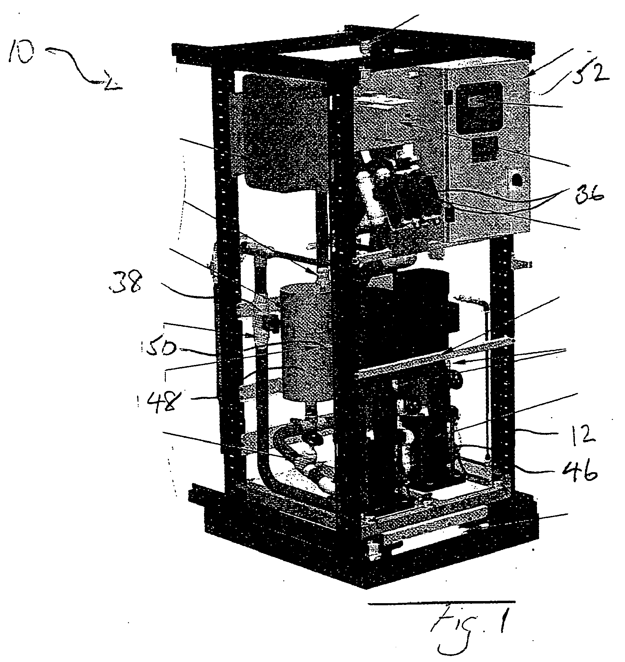

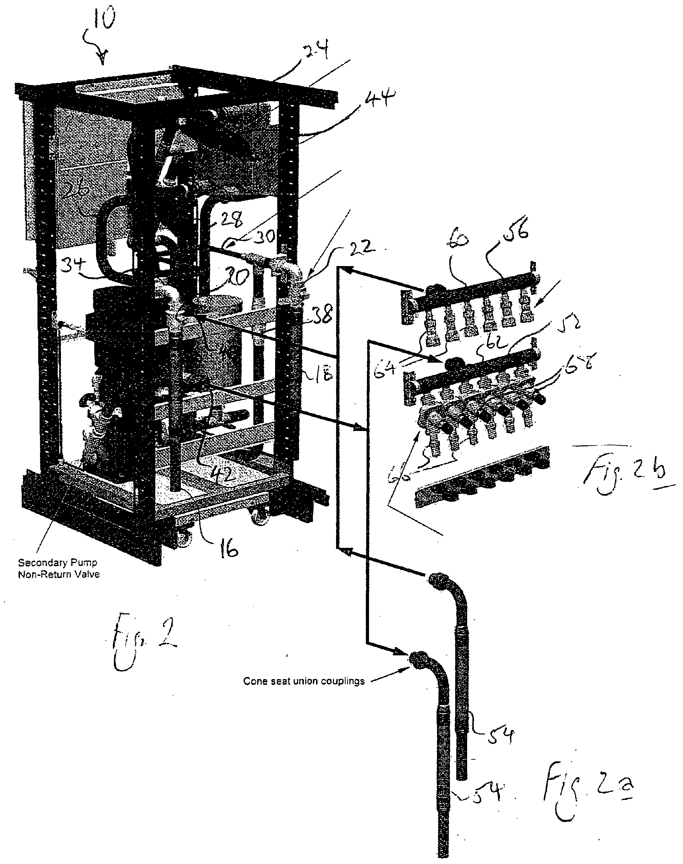

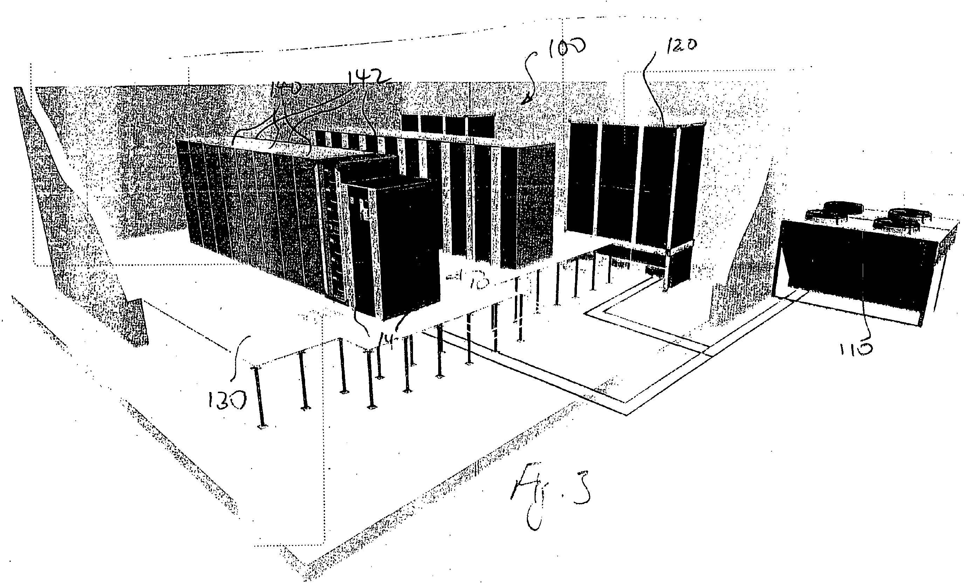

The cooling distribution unit 10 shown in Figures 1 and 2 comprises a metal frame 12 enclosed in sheet metal panelling 14 (shown in Figure 3, but not shown in Figures 1 and 2 to enable the component parts of the unit to be revealed).

The frame 10 supports a primary circuit inlet 16 and a primary circuit outlet 18 connected via respective isolation valves 20 and 22 to a plate heat exchanger 24. The primary circuit inlet 16 is connected to the plate heat exchanger 24 via a filter 28. A bypass circuit 30 having a shut-off valve 34 interconnects the primary circuit inlet and outlet 16 and 18 downstream and upstream respectively of the isolation valves 20 and 22, to bypass the heat exchanger 24. The primary circuit outlet 18 is connected to the plate heat exchanger 24 via primary circuit control valves 36 connected in parallel with one another, one acting as a standby for the other, and via a primary circuit flowmeter 38.

The unit 10 is also provided with a secondary circuit inlet 40 and a secondary circuit outlet 42. The inlet 40 is connected via a secondary circuit filter 44 to the plate heat exchanger 24. The secondary circuit outlet 42 is connected to the heat exchanger 24 via run and standby secondary pumps 46 which are in parallel with one another, and a secondary circuit reservoir tank 48 provided with a level switch 50.

The control valves 36, the flowmeter 38, the secondary circuit pumps 46, and the level switch 50 are all electronically connected to a control and display unit 52.

The secondary circuit inlet and outlet 40 and 42 respectively may be connected to respective flexible tailpipes 54 (shown in Figure 2a) which extend downwardly to respective under-floor manifolds (shown in Figure 2a).

Alternatively, the secondary circuit inlet and outlet 40 and 42 may be connected directly to respective manifolds 56 and 58, as shown in Figure 2b. These manifolds have respective common chambers 60 and 62 and respective sets of quick release couplings 64 and 66. The quick release couplings 66 of the secondary circuit outlet or supply manifold 58 are provided with respective control valves 68.

Figure 3 shows a data centre 100 provided with a chiller unit 110 connected to supply cooled water to perimeter cooling 120 and also to the primary circuit of the cooling distribution unit 10. The latter is provided with flexible tailpipes 54 as shown in Figure 2a (but not visible in Figure 3) and under raised flooring 130 of the data centre. 100. The cooling distribution unit 10 is provided with manifolds like those shown in Figure 2b but connected to the ends of the flexible tailpipes 54 which are further from the cooling distribution unit 10. The data centre 100 is provided with rows of blade racks 140, the blade racks 140 being provided with respective rear door heat exchangers 142. Each of up to six rear door heat exchangers 142 of respective blade racks 140 are connected to the secondary circuit of the cooling distribution unit 10 via respective outlets 66 and inlets 64 thereof (again not visible in Figure 3).

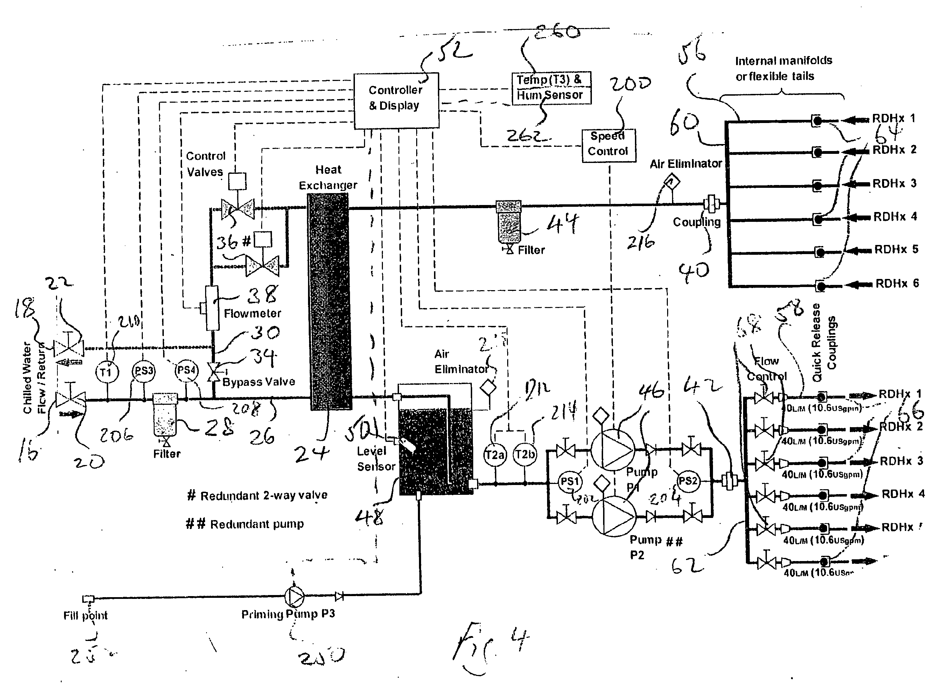

The fluid and electrical circuitry of the cooling distribution unit 10 shown in Figures 1 to 3 is shown more clearly in Figure 4 in which parts corresponding to what is shown in Figures 1 and 2 are given the same reference numerals as in Figures 1 and 2.

Additional components of the cooling distribution unit 10, more readily apparent from Figure 4, comprise a speed controller 200 electrically connected between the control and display unit 52 and the pumps 46, pressure meters 202, 204, 206 and 208 all connected to the control and display unit 52 and located to measure the pressure of the coolant flowing immediately upstream and downstream respectively of the pumps 46 and upstream and downstream respectively of the filter 28. Thermometers 210, 212, 214 are also connected electrically to the control and display unit 52 and are located to provide a measure of the temperature of coolant flowing immediately upstream of the filter 28 and of coolant flowing at two spaced apart locations downstream of the secondary circuit reservoir tank 48 but upstream of the pumps 46.

Air eliminators 216, 218 are provided respectively at locations downstream of the secondary circuit inlet 40 and in the reservoir tank 48.

A filling pump 250 is connected to pump cooling fluid from a source 252 hereof into the reservoir tank 48.

A thermometer or other temperature sensor 260 located in the data centre 100 when the unit 10 is in use is connected to the control and display unit 52, as is a humidity sensor 262.

With the cooling distribution unit 10 and other apparatus connected as shown in Figures 3 and 4, the equipment operates as follows.

The chiller 110 provides cool water for the primary circuit of the cooling distribution unit 10 and also for the perimeter cooling 120. At the same time, that one of the pumps 46 for the time being acting as the main pump supplies water from the reservoir tank 48 to the output 42 of the unit 10 and, via respective outlets of the manifold 58 to respective rear door heat exchangers 142 of the blade racks 140. Water from the rear door heat exchangers 142 is returned via piping (not shown) to respective inlets of the manifold 60 to the cooling distribution unit 10 where it passes via the filter 44 to the plate heat exchanger 24 and back to the reservoir tank 48. In the event that the liquid level in the latter as sensed by the level sensor 70 deceeds a predetermined threshold level stored in the control and display unit 52, the tank is replenished by water from the source 252 via the pump 250.

The flow control valve 68, and the speed of the pump 46 are adjusted as appropriate for the respective rear door heat exchangers cooled by the water in the secondary circuit.

The control and display unit 52 continuously monitors humidity of the data centre by way of the humidity sensor 262. This in turn determines the dew point in the data centre assuming a pressure of substantially one atmosphere for the air in the data centre. The temperature of air in the data centre, more especially air close to the ceiling thereof, is monitored by the control and display unit 52 by virtue of its connection to the appropriately located thermometer or temperature sensor 260. The temperature of the water immediately downstream of the secondary circuit reservoir tank is monitored by way of either of the thermometers 212 and 214 and the control and display unit 52. In the event that the temperature difference between that temperature and the ambient dew point deceeds a predetermined safe threshold value, the control valves 36 are closed a little by the control and display unit 52 to raise the temperature of the water in the secondary circuit, to increase the temperature difference and reduce the likelihood of condensation in the rear door heat exchangers 142.

Numerous variations and modifications to the illustrated cooling distribution unit may occur to a reader of the specification without taking the unit outside the scope of the present invention. To give one example only, the control and display unit 52 may also be provided with an input from a pressure sensor (not shown) also located within the data centre, and the control and display unit 52 may be further programmed to calculate the dew point more accurately on the basis of the inputs from both its humidity sensor and such a pressure sensor.

## Claims

1. A method of cooling air in a space, the method comprising:
pumping coolant fluid through primary and secondary circuits having respective portions thermally coupled within a primary heat exchanger so that the coolant fluid in the primary circuit conditions the coolant fluid in the secondary circuit;
distributing the coolant fluid in the secondary circuit to at least one secondary heat exchanger positioned with a space;
monitoring an ambient dew point of the space with a sensor; and
controlling a parameter of coolant fluid in the primary circuit based on the ambient dew point to reduce condensation in the space.

2. The method of claim 1, wherein controlling a parameter of coolant fluid in the primary circuit includes controlling a flow rate of the coolant fluid in the primary circuit.

3. The method of claim 1, wherein the parameter of the coolant fluid in the primary circuit is adjusted to alter a temperature of the coolant fluid in the secondary circuit.

4. The method of claim 1 further comprising monitoring a temperature of the air in the space.

5. The method of claim 2 further comprising monitoring a humidity of the air in the space to determine the ambient dew point of the air in the space.

6. The method of claim 3 further comprising monitoring a pressure of the air in the space to determine the ambient dew point of the air in the space.

7. The method of claim 3 further comprising:
monitoring a temperature of the coolant fluid in the secondary circuit; and
comparing the temperature of the coolant fluid in the secondary circuit to the ambient dew point of the space.

8. A cooling unit comprising:
a fluid circuit through which coolant fluid is pumped, a portion of the fluid circuit positioned within a space through which air flows;
a sensor positioned within the space, the sensor determining an ambient dew point of the air in the space; and
a parameter adjuster to adjust a parameter of the coolant fluid in the fluid circuit based on the ambient dew point in the space.

9. The cooling unit of claim 8, wherein the parameter adjuster adjusts a temperature of the coolant fluid in the fluid circuit.

10. The cooling unit of claim 8, wherein the space includes heat-generating electronic equipment which is to be cooled.

11. The cooling unit of claim 8, wherein the sensor determines a temperature of the air in the space.

12. The cooling unit of claim 8, wherein the sensor determines a humidity of the air in the space to determine the ambient dew point of the space.

13. The cooling unit of claim 8, wherein the sensor determines a pressure of the air in the space to determine the ambient dew point of the space.

14. The cooling unit of claim 8 further comprising a sensor to determine a temperature of the coolant in the fluid circuit, the temperature of the coolant in the fluid circuit compared to the ambient dew point of the space.

15. A method of cooling air in a space, the method comprising:
channeling the air through a space;
pumping coolant fluid through a fluid circuit flowing through the space;
monitoring an ambient dew point of the air in the space with a sensor; and
controlling a parameter of the coolant fluid in the fluid circuit based on the ambient dew point to reduce condensation in the space.

16. The method of claim 15, wherein controlling a parameter of the coolant fluid includes controlling a temperature of the coolant fluid.

17. The method of claim 15 further comprising monitoring a temperature of the air in the space.

18. The method of claim 15 further comprising monitoring a humidity of the air in the space to determine the ambient dew point of the air in the space.

19. The method of claim 15 further comprising monitoring a pressure of the air in the space to determine the ambient dew point of the air in the space.

20. The method of claim 15 further comprising:
monitoring a temperature of the coolant fluid in the fluid passageway; and
comparing the temperature of the coolant fluid in the fluid passageway to the ambient dew point of the space.
